# EUROPEAN PATENT APPLICATION

(11) **EP 2 448 385 A2**
(43) Date of publication of application: **02.05.2012**
(21) Application number: 11185425.3
(22) Date of filing: 17.10.2011
(51) Int. Cl.: H05K 5/02

(54) **Dewing prevention structure for substrate**

(30) Priority: 29.10.2010 JP 2010243981
(71) Applicant: Aisin AW Co., Ltd., Fuji-cho Anjo-shi Aichi 444-1192 (JP)
(72) Inventor: Michida, Toshifumi, Anjo-shi,, Aichi 444-1192 (JP)
(74) Representative: TBK

(57) **Abstract**

The application refers to a dewing prevention structure for a substrate (60) accommodated in a housing (10) that has an opening (13) allowing an inflow of outer air. The dewing prevention structure suppresses dew condensation on the substrate (60), wherein a heat conductive member (70) is provided inside the housing (10), and the heat conductive member (70) contacts each of a predetermined heat source (61) inside the housing (10) and an area of the substrate (60) near the opening (13).

## Description

### INCORPORATION BY REFERENCE

The disclosure of Japanese Patent Application No. 2010-243981 filed on October 29, 2010 including the specification, drawings and abstract is incorporated herein by reference in its entirety.

### BACKGROUND OF THE INVENTION

The present invention relates to a dewing prevention structure for a substrate.

### Description of the Related Art

To prevent electro-chemical migration on a substrate accommodated in a housing of various types of electronic devices, a dew condensation preventive device is proposed in related art to prevent dew condensation on a surface of the substrate. In an electronic unit case according to Japanese Patent Application Publication No. JP H09-102679 A, for example, a dew condensation preventive plate is provided around a conductor exposed on a surface of a printed circuit board, and located at a position for preventing a flow of outer air. With this dew condensation preventive device, even if high-temperature outer air penetrates to inside the case, the humidity of the outer air is reduced and the conductor is less susceptible to dewing because the outer air blows toward and generates dew on the dew condensation preventive plate that is cooled under a low-temperature environment.

Alternatively, dew condensation is also prevented by coating the surface of the printed circuit board with a protective film for preventing dew condensation.

### SUMMARY OF THE INVENTION

However, according to the dew condensation preventive device of the related art described above, if a plurality of conductors is provided on the printed circuit board, the conductors must be arranged in a concentrated manner at a location that is easily surrounded by the dew condensation preventive plate, which places restrictions on the substrate with respect to the layout design of the electronic unit.

With regard to the method for coating the surface of the printed circuit board with a protective film, in addition to the high cost of the coating agent, special equipment must be provided for storing the coating agent and the like, which significantly increases the manufacturing costs of the electronic device.

The present invention was devised in light of the foregoing, and it is an object of the present invention to provide a dewing prevention structure for a substrate that can suppress dewing on the substrate, lessen restrictions on the substrate with respect to a layout design of an electronic unit, and reduce the manufacturing costs of an electronic device compared to when a coating agent is used.
The above object is solved with a dewing preventive structure having the features of claim 1. Further embodiments are defined in the dependent claims.

In a dewing prevention structure for a substrate according to claim 1, a predetermined heat source inside a housing and an area of a substrate are each in contact with the same heat conductive member. Therefore, some heat discharged from the predetermined heat source is transferred to the area of the substrate through the heat conductive member. Even if a plurality of conductors is provided on the substrate, the dewing prevention structure for a substrate can be applied without affecting the layout of the conductors, and thus lessen restrictions on the substrate with respect to the layout design of an electronic unit. In addition, the dewing prevention structure for a substrate uses a relatively low-cost heat conductive member, and can be manufactured without special equipment. Therefore, the manufacturing costs of an electronic device can be reduced compared to when a coating agent is used.
In the dewing preventing structure for a substrate according to claim 2, the area of the substrate is near the opening and is thus an area in which dew condensation is likely to occur. With this structure, some heat discharged from the predetermined heat source is transferred to the area of the substrate through the heat conductive member, such that dew condensation on the substrate in the area near the opening can be suppressed.

In the dewing prevention structure for a substrate according to claim 3, the heat conductive member includes a heat sink provided on the substrate for dissipating heat radiated from the predetermined heat source. Utilizing the existing heat sink, for example, thus enables the dewing prevention structure for a substrate to be applied without performing hardly any design changes to the substrate, the housing, and the like. This further lessens the restrictions on the substrate with respect to the layout design of the electronic unit. In addition, the material costs of the dewing prevention structure for a substrate can be further reduced by using the heat sink, which further reduces the manufacturing costs of the electronic device.

In the dewing prevention structure for a substrate according to claim 4, the opening is a connector insertion opening for inserting inside the housing a connector to be connected to the substrate. Therefore, when high-temperature outer air penetrates to inside the housing through the connector insertion opening, the substrate is less susceptible to dew condensation.

### BRIEF DESCRIPTION OF THE DRAWINGS

FIG. 1 is a perspective view of a navigation device as viewed from a front side;
FIG. 2 is a perspective view of the navigation device as viewed from a rear side;
FIG. 3 is a plane view of an essential portion centered on a substrate;
FIG. 4 is a cross-sectional view of an essential portion of the navigation device based on a cross section A-A shown in FIG. 2; and
FIG. 5 is a diagram that illustrates a heat conduction state.

### DETAILED DESCRIPTION OF THE EMBODIMENT

Hereinafter, an embodiment of a dewing prevention structure for a substrate according to the present invention will be described in detail with reference to the drawings. However, the present invention is not limited to such an embodiment. Further note that the dewing prevention structure for a substrate according to the present invention may be applied to any electronic device, with such electronic devices including a navigation device and a car stereo installed in an automobile, for example. In the present embodiment, an example in which the dewing prevention structure for a substrate is applied to a navigation device will be described.

### Constitution

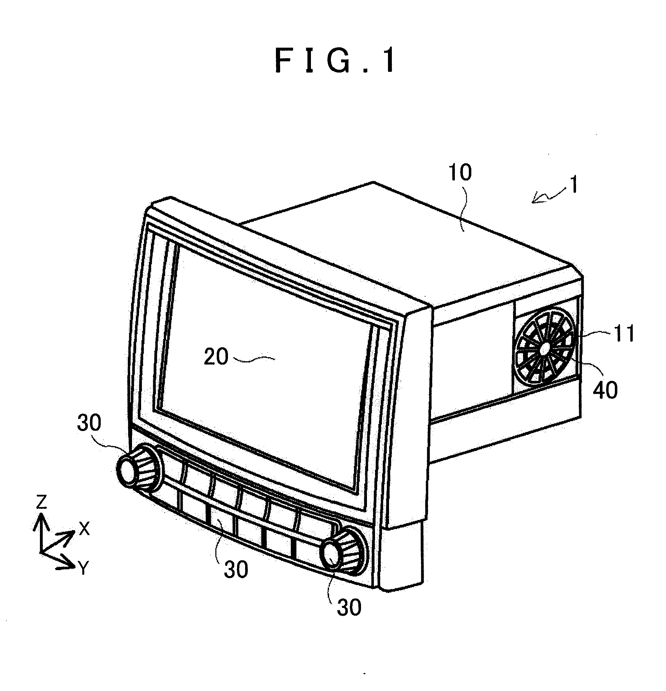

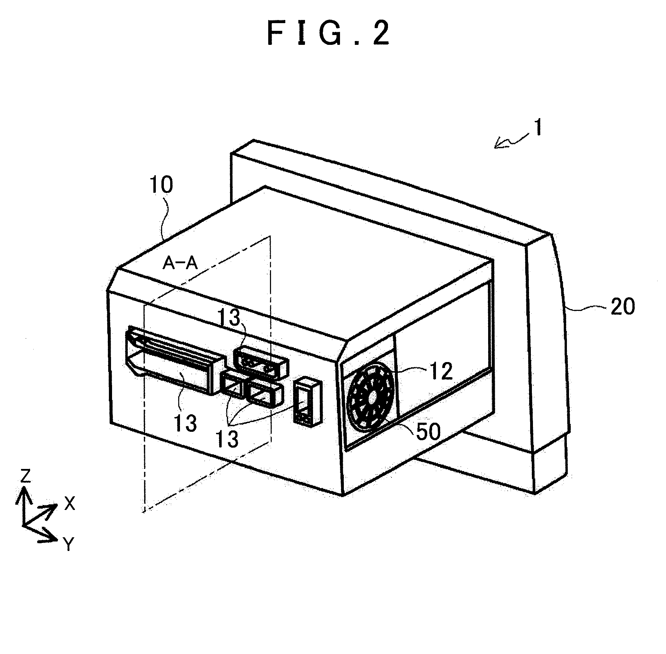

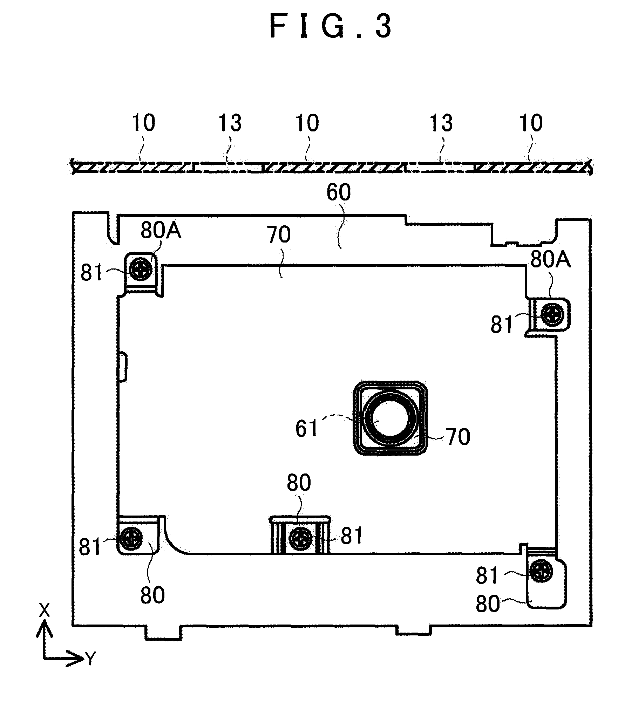

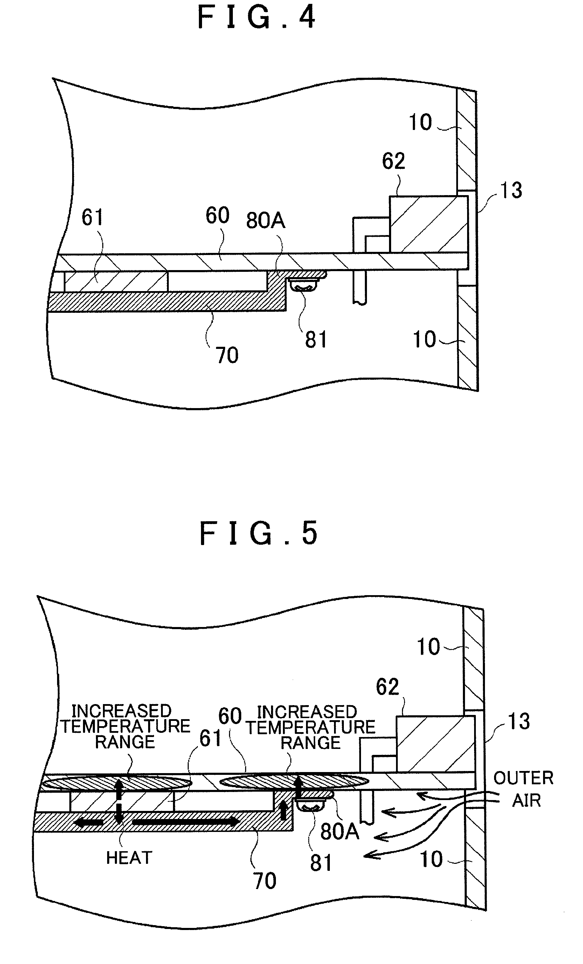

First, the basic constitution of the navigation device will be described. FIG. 1 is a perspective view of the navigation device as viewed from a front side. FIG. 2 is a perspective view of the navigation device as viewed from a rear side. FIG. 3 is a plane view of an essential portion centered on a substrate. FIG. 4 is a cross-sectional view of the essential portion of the navigation device in FIG. 3 based on a cross section A-A shown in FIG. 2. In the following description, the X direction in FIG. 1 is a front-rear direction, the Y direction is a left-right direction, and the Z direction is an up-down direction.

A navigation device 1 is configured to accommodate a substrate 60 (shown only in FIGS. 3, 4, and 5 described later) that is mounted with various components (e.g., a CPU 61 described later, a condenser, an EEPROM, and a receiving-side connector 62 described later) inside a housing 10. The housing 10 is a hollow box-like body that is formed of a resin material.

As shown in FIG. 1, a display 20 and an operation portion 30 are provided at the front of the housing 10. The display 20 is a display unit that displays various types of images, and is formed as a flat panel display such as a commonly known liquid crystal display or organic EL display. The operation portion 30 is an operation unit that receives operational input from a user, and is formed as a touch panel provided on a front surface of the display 20, and as buttons and dials provided below the display 20, for example.

As shown in FIGS. 1 and 2, an intake opening 11 is provided on one of left and right side surfaces of the housing 10, and an exhaust opening 12 is provided on the other of the left and right side surfaces of the housing 10. The intake opening 11 is provided with an intake fan 40, and outer air can be introduced to inside the housing 10 through the intake fan 40. The exhaust opening 12 is provided with an exhaust fan 50, and air inside the housing 10 can be discharged to outside through the exhaust fan 50.

As shown in FIG. 3, a substrate 60 is disposed inside the housing 10. The substrate 60 is a printed circuit board that is disposed in a horizontal manner along the front-rear direction and the left-right direction. The substrate 60 is fixed to an attachment stay, not shown, provided on an inner wall of the housing 10. The various components noted above are provided on a side surface of the substrate 60. Among these components, there are components that become heat sources that give off heat when carrying a current, such as the CPU 61 and the condenser, for example. Although the following description is an example in which the CPU 61 is the heat source, the dewing prevention structure described later for the substrate 60 may be applied in a similar manner to other components acting as heat sources. As shown in FIG. 3, the CPU 61 is mounted near a substantially center of a flat surface of the substrate 60 in the front-rear direction and the left-right direction. Also, as shown in FIG. 4, the substrate 60 is mounted with the receiving-side connector (connection plug seat) 62 (not shown in FIG. 3). The receiving-side connector 62 is detachably connected to an inserting-side connector (connection plug) (not shown).

In addition, as shown in FIG. 2, a plurality of connecter insertion openings 13 is provided on a back surface of the housing 10. Each of the plurality of connector insertion openings 13 is an opening for connecting the inserting-side connector, which is inserted from outside the housing 10, to the receiving-side connector 62 provided inside the housing 10. Each of the plurality of connector insertion openings 13 is also formed into a shape that corresponds to the shapes of the receiving-side connector 62 and the inserting-side connector as specified by standards. When the inserting-side connector is not inserted into the connector insertion opening 13, there is a possibility that outer air outside the housing 10 may flow in through a space between the connector insertion opening 13 and the receiving-side connector 62. Even when the inserting-side connector is inserted into the connector insertion opening 13, there is still a possibility that outer air outside the housing 10 may flow in through a space between the connector insertion opening 13, the inserting-side connector, and the receiving-side connector 62.

### Constitution: Dewing Prevention Structure of Substrate

Next, the dewing prevention structure of the substrate 60 in the navigation device 1 thus configured will be described. The dewing prevention structure of the substrate 60 is a structure for suppressing dew condensation on a surface of the substrate 60, in order to prevent electro-chemical migration on the substrate 60 accommodated in the housing 10 of the navigation device 1.

As shown in FIG. 4, a heat sink 70 is also provided inside the housing 10 in addition to the substrate 60 and the receiving-side connector 62 described above. The heat sink 70 is used to dissipate heat radiated from the CPU 61, and is a heat conductive member formed of a material with high heat conductivity, such as copper or aluminum. Although the heat sink 70 except for attachment stays 80 and 80A is shaped overall as a plane rectangular plate here, the heat sink 70 may include a fin for increasing heat transfer efficiency.

Among upper and lower side surfaces of the substrate 60, the heat sink 70 is disposed on a side surface to which the CPU 61 is also mounted, and the heat sink 70 is fixed to the substrate 60 in a state of contact with the CPU 61. More specifically, the heat sink 70 is disposed parallel to the CPU 61, and at least a part of one side surface of the heat sink 70 is in contact with substantially the whole surface of one side surface of the CPU 61. Note that the heat sink 70 may be contact in with other components (other heat sources) mounted on the substrate 60 while being in contact with the CPU 61 as described above.

Near each corner portion of the heat sink 70, as shown in FIG. 3, the attachment stays 80 and 80A are integrally formed extending toward the substrate 60. Further, as shown in FIGS. 3 and 4, each of the attachment stays 80 and 80A is threadedly fastened to the substrate 60 by a screw 81, whereby the heat sink 70 is fixed to the substrate 60 and the heat sink 70 is in contact with the substrate 60.

Here, areas where the heat sink 70 contacts the substrate 60 (areas where the attachment stays 80 and 80A are formed) are set such that at least one area is an area where the substrate 60 is more susceptible to dew condensation. Such an area more susceptible to dew condensation includes an area where outer air is highly likely to contact the substrate 60, such as an area of the substrate 60 near the connector insertion opening 13 (as an example, an area within several centimeters away from the connector insertion opening 13). Therefore, in FIG. 3, among the attachment stays 80 and 80A, the attachment stays 80A indicated by an imaginary line are formed in the area near the respective connector insertion opening 13, and the heat sink 70 contacts the substrate 60 at the location of the attachment stay 80A.

### Operation

Next, the operation of the dewing prevention structure of the substrate 60 thus configured will be described. FIG. 5 is a diagram that illustrates a heat conduction state.

First, after a power source of the navigation device 1 is turned on and a predetermined time elapses, the current-carrying CPU 61 discharges heat. In this case, some of the heat discharged from the CPU 61 is transferred to an area of the substrate 60 in contact with the CPU 61. This results in an increased temperature at the area of the substrate 60 in contact with the CPU 61 and surrounding areas.

Meanwhile, the remaining heat discharged from the CPU 61 is transferred to the heat sink 70 through contacting surfaces of the CPU 61 and the heat sink 70. Due to the high heat conductivity of the heat sink 70, such heat is efficiently conducted to the area of the substrate 60 near the connector insertion opening 13. This heat is then transferred to the substrate 60 through contacting surfaces of the heat sink 70 and the substrate 60. Therefore, the temperature at the area of the substrate 60 near the connector insertion opening 13 and surrounding areas increases.

Based on the above, with the dewing prevention structure of the substrate 60, for example, if the substrate 60 was exposed and cooled under a low-temperature environment, the high-temperature outer air may penetrate to inside the housing 10 through the connector insertion opening 13 and blow toward the area of the substrate 60 near the connector insertion opening 13. Even in such case, heat transferred from the CPU 61 to the substrate 60 through the heat sink 70 warms up the area of the substrate 60 near the connector insertion opening 13, thus making the substrate 60 less susceptible to dew condensation caused by outer air. Therefore, electro-chemical migration can be effectively prevented.

### Effects

According to the present embodiment described above, the dewing prevention structure of the substrate 60 brings the CPU 61 inside the housing 10 and the area of the substrate 60 near the connector insertion opening 13 in contact with the same heat conductive member, i.e. the heat sink 70. Therefore, some heat discharged from the CPU 61 is transferred to the area of the substrate 60 near the connector insertion opening 13 through the heat conductive member, which can suppress dew condensation on the substrate 60. Even if a plurality of conductors is provided on the substrate 60, the dewing prevention structure of the substrate 60 can be applied without affecting the layout of the conductors, and thus lessen restrictions on the substrate 60 of the navigation device 1 with respect to the layout design of an electronic unit. In addition, the dewing prevention structure of the substrate 60 uses a relatively low-cost heat conductive member, and can be manufactured without special equipment. Therefore, the manufacturing costs of the navigation device 1 can be reduced compared to when a coating agent is used.

The heat conductive member includes the heat sink 70 provided on the substrate 60 for dissipating heat radiated from the CPU 61. Utilizing the existing heat sink 70, for example, thus enables the dewing prevention structure of the substrate 60 to be applied without performing hardly any design changes to the substrate 60, the housing 10, and the like. This further lessens the restrictions on the substrate 60 of the navigation device 1 with respect to the layout design of the electronic unit. In addition, the material costs of the dewing prevention structure of the substrate 60 can be further reduced by using the heat sink 70, which further reduces the manufacturing costs of the navigation device 1.

The connector insertion opening 13 is an opening for inserting inside the housing 10 the connector to be connected to the substrate 60. Therefore, when high-temperature outer air penetrates to inside the housing 10 through the connector insertion opening 13, the substrate 60 is less susceptible to dew condensation.

### Modifications of the Embodiment

An embodiment of the present invention was explained above. However, the specific configuration and units for implementing the present invention may be modified and improved in any manner or form within the scope of the technical ideas of the present invention as set forth in the claims thereof. Examples of such modifications are explained below.

### Problems to be Solved by the Invention and Effects of the Invention

The problems to be solved by the present invention and the effects of the present invention are not limited to the content described above and may vary depending on the environment in which the present invention is practiced and the detailed configuration thereof. The above problems may be only partially solved, and the above effects only partially achieved.

### Predetermined Heat Source Provided Inside Case Body

In the embodiment described above, the predetermined heat source provided inside the housing 10 is a component such as the CPU 61 provided on the substrate 60. However, the present invention is not limited to this example. As another example, the predetermined heat source may be a component such as a speaker amp or the like inside the housing 10 that is not mounted on the substrate 60. Alternatively, if heat discharged from an instrument such as a heater provided outside the housing 10 is transferred to the housing 10 and a side wall of the housing 10 is warmed up by such heat, the side wall may also be utilized as the heat source.

### Heat Conductive Member

In the embodiment described above, the heat conductive member is the heat sink 70. However, the heat conductive member may any type of member that has high heat conductivity, such as a copper plate or aluminum plate, for example. In addition, the heat conductive member may be an assembly of a plurality of members. For example, a copper plate or an aluminum plate may be connected to the existing heat sink 70 whose size corresponds to the shape of the CPU 61, and may further be connected to an area of the substrate 60 near the opening. Thus, the heat of the heat source may be transferred to the substrate 60 through the heat sink 70, and the copper plate or the aluminum plate. Moreover, as a method of fixing the heat conductive member, adhesion or welding is also conceivable in addition to the threaded fastening described above. Alternatively, provided that the heat conductive member at least contacts the substrate 60, the heat conductive member may not necessarily be fixed.

### Opening Allowing Inflow of Outer Air

In the embodiment described above, the opening allowing an inflow of outer air is the connector insertion opening 13. However, the present invention is not limited to this example. As another example, the opening may be the intake opening 11 or the discharge opening 12 provided on the side surface of the housing 10, or an insertion opening for inserting a DVD disc or the like (not shown) provided at the front of the housing 10.

### Dewing Prevention Structure of Substrate

In the embodiment described above, the dewing prevention structure of the substrate 60 puts the heat sink 70 in contact with each of the CPU 61 inside the housing and the area of the substrate 60 near the connector insertion opening 13. However, the dewing prevention structure of the substrate 60 may combine the dewing prevention structure of the substrate 60 with another dewing prevention structure or the like. For example, an area among the area of the substrate 60 near the connector insertion opening 13 that cannot contact the heat sink 70 due to layout space restrictions (an area of the substrate 60 that contacts the receiving-side connector 62 shown in FIG. 5) may be coated with a protective film for preventing dew condensation. In this case as well, it is possible to reduce the manufacturing cost of the navigation device 1 because a smaller amount of coating agent can be used compared to the related art.
The application refers to a dewing prevention structure for a substrate (60) accommodated in a housing (10) that has an opening (13) allowing an inflow of outer air. The dewing prevention structure suppresses dew condensation on the substrate (60), wherein a heat conductive member (70) is provided inside the housing (10), and the heat conductive member (70) contacts each of a predetermined heat source (61) inside the housing (10) and an area of the substrate (60) near the opening (13).

## Claims

1. A dewing prevention structure for a substrate (60) accommodated in a housing (10) that has an opening (13) allowing an inflow of outer air, the dewing prevention structure suppressing dew condensation on the substrate (60), wherein
a heat conductive member (70) is provided inside the housing (10), and
the heat conductive member (70) contacts each of a predetermined heat source (61) inside the housing (10) and an area of the substrate (60).

2. The dewing prevention structure for a substrate (60) according to claim 1, wherein the area of the substrate (60) is an area near the opening (13).

3. The dewing prevention structure for a substrate (60) according to claim 1 or 2, wherein
the predetermined heat source (61) is a component mounted on the substrate (60), and
the heat conductive member (70) includes a heat sink (70) provided on the substrate (60) for dissipating heat radiated from the component (61).

4. The dewing prevention structure for a substrate according to any one of claims 1 to 3, wherein
the opening (13) is a connector insertion opening (13) for inserting inside the housing (10) a connector to be connected to the substrate (60).
